# EUROPEAN PATENT SPECIFICATION

(11) **EP 2 868 169 B1**
(45) Date of publication and mention of the grant of the patent: **15.06.2016**
(21) Application number: 12741369.8
(22) Date of filing: 03.08.2012
(51) Int. Cl.: H05K 1/16, A63B 43/00

(54) **CONCEPT FOR ASSEMBLING AN ELECTROMAGNETIC COIL USING A FLEXIBLE PRINTED CIRCUIT BOARD**
KONZEPT ZUM ZUSAMMENBAU EINER ELEKTROMAGNETISCHEN SPULE MIT EINER FLEXIBLEN BESTÜCKTEN LEITERPLATTE
CONCEPT PERMETTANT D'ASSEMBLER UNE BOBINE ÉLECTROMAGNÉTIQUE À L'AIDE D'UNE CARTE DE CIRCUIT IMPRIMÉ FLEXIBLE

(30) Priority: 27.06.2012 EP 12173967; 27.06.2012 US 201261665012 P
(43) Date of publication of application: 06.05.2015
(73) Proprietor: Fraunhofer-Gesellschaft zur Förderung der angewandten Forschung e.V., 80686 München (DE)
(72) Inventor: TRÖGER, Hans-Martin, 91054 Erlangen (DE); HARTMANN, Markus, 92237 Sulzbach-Rosenberg (DE)
(74) Representative: 2SPL Patentanwälte PartG mbB
(86) International application number: PCT/EP2012/065298
(87) International publication number: WO 2014/000828

(56) References cited:
- EP-A1- 2 363 177
- DE-A1-102007 048 818
- DE-A1-102008 052 621
- FR-A1- 2 865 329
- US-A- 4 755 783
- US-A1- 2003 187 347
- US-A1- 2006 043 199
- US-A1- 2011 118 062
- US-A1- 2012 029 343
- US-A1- 2012 081 258
- US-B1- 6 620 057

## Description

Embodiments of the present invention generally relate to flexible Printed Circuit Boards (PCBs) and, more particularly, to flexible electromagnetic coils fabricated by means of flexible PCBs.

### Background

An electromagnetic coil, or simply a coil, is formed when an electrical conductor, such as e.g. a copper wire, is wound to create an inductive or electromagnetic element. Thereby the wire may also be wound around a core or form. One loop of wire may be referred to as a turn, and a coil comprises one or more turns. Coils serving as inductors are widespread in electronic circuits as a passive two-terminal electrical component that stores energy in its magnetic field. US 4 755 783 A describes inductive devices, i.e., transformers, coils, inductors, etc. that are produced from a rolled flexible circuit. Inductive coils on flexible substrate are disclosed in US 2012/029343 A1. For example, coils may be used for realizing transformers for transferring energy from one electrical circuit to another by inductive coupling without moving parts. Also, coils may be used to build resonant circuits comprising serial and/or parallel arrangements of inductors and capacitors. In some applications coils may also serve as antennas or antenna-like elements for detecting electromagnetic fields, such as e.g. in Radio Frequency Identification (RFID) or similar applications. Examples of RFID tags can be found in US 2006/043199 A1 or FR 2 865 329 A1. US 2012/081258 A1 describes a compact coil antenna that can operate even if the coil antenna is arranged closely to its conductor plate, and that has a high degree of coupling with a target antenna. As described in US 2003/0187347 A1, coils can also be used in endoscopic examining apparatuses.

In one of such applications, for example, it is proposed to detect a transition of a moving playing object, such as a ball or a puck, through a detection plane (e.g. a goal plane) using electromagnetic fields and/or signals. In some ball sports, as e.g. soccer or football, the usage of automated goal-detection systems is discussed in order to avoid human wrong decisions. Thereby the so-called goal-line technology is a technology, which can determine when the ball has crossed the goal line, assisting the referee in calling a goal or not. There are various alternative approaches for determining the exact position or location of the ball, such as video-based or electromagnetic field based systems. In an electromagnetic field based system a moving object, such as a ball, may be equipped with electronic circuitry for transmitting and/or receiving and/or reflecting electro-magnetic signals. Examples for electronic circuitry inside a ball can be found in US 2011/118062 A1 or DE 10 2008 052 621 A1. For such electromagnetic approaches electronic components are required inside the ball, wherein the size of the electronics may differ depending on its functionality and the used frequency range. For small and medium-sized systems the electronic may be installed within the ball's center, for example. For goal-detection systems requiring more area and volume, as e.g. for systems using magnetic fields in the sub-MHz range, the required loop antennas and/or the further electronic components may be installed on the circumference of the ball. Alternative approaches for determining the position or location of a ball are described in DE 10 2007 048 818 A1, US 6 620 057 B1, or EP 2 363 177 A1

For achieving detection properties which are possibly rotationally invariant, one goal-detection system proposes to install three orthogonally placed coils or loop-antennas within or on a moving object, e.g., a ball, for emitting or reflecting at least a portion of an electromagnetic field. Due to this orthogonal arrangement of the coils the rotational position of the ball only has little influence on the electromagnetic emission or reflection properties, as in theory the three orthogonal loop-antennas always amount to an effective loop-antenna, whose effective opening surface is perpendicular to an incident magnetic field coming from a transmitter installed at or near the goal. That is to say, the normal of the effective opening surface is essentially parallel to the magnetic field vector.

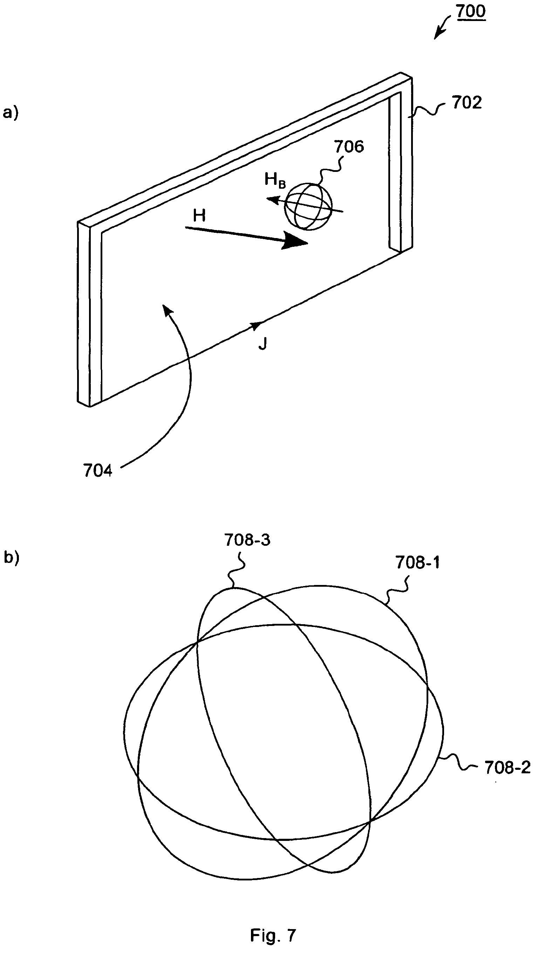

For a correct functioning, i.e. high precision, of goal-detection systems electromagnetic properties of the ball or a puck are a crucial criterion. In one exemplary goal-detection system 700 (see Fig. 7a) a magnetic field *̅H̅*̅ may be generated by means of a current-carrying conductor embracing a goal frame 702. The generated magnetic field *̅H̅*̅ is thereby perpendicular to a detection plane 704 defined by the goal frame 702. This stimulating magnetic field *̅H̅*̅ is reflected by the ball 706, wherein the reflected signal *H̅_{B}* should generate the same directional vector as the stimulating field *̅H̅*̅ (due to the ball electronics with a shifted phase). The geometric accuracy of the reflected signal directly influences the measurement result and, hence, the accuracy of the goal decision.

The detection system 700 is based on three orthogonal coils 708-1, 708-2, 708-3 in the ball 706 (see Fig. 7b). Each of the coils 708-1, 708-2, 708-3 may comprise a plurality of turns which may, for example, be inserted in between the ball bladder and the ball hull. For avoiding any irregularities in the ball hull the inserted coils 708-1, 708-2, 708-3 should be rather flat between the ball bladder and the ball hull (i.e. the ball cover). Hence, the windings or turns of the coil should be arranged possibly side-by-side along the circumference of the ball 706.

The fabrication of items of sports equipment or playing equipment, such as balls, being equipped with more or one coils or loop-antennas, in particular arranged on its circumference, is relatively cumbersome. Furthermore, the exact positioning of the coils within or around the ball is crucial. Hence, it is desirable to provide a concept to ease the production and/or the positioning of the antenna coils.

### Summary

It is one finding of the present invention to manufacture or fabricate a flexible and preferably elastic coil or a loop-antenna using flexible electronics, also referred to as flex circuits. This is a proven technology for assembling electronic circuits by mounting electronic devices on flexible plastic substrates, such as polyimide, PolyEther Ether Ketone (PEEK), thermoplastic polyurethane (TPU), or polyester. Such flexible plastic substrates are also elastic allowing for elastic expansion and contraction of the flexible coil. Flexible electronic assemblies may be manufactured using the same components used for rigid Printed Circuit Boards (PCBs), allowing a flexible PCB to conform to a desired shape, or to flex during its use. According to embodiments the desired shape of the flexible PCB is that of a coil or a loop-antenna. Flexible printed circuits (FPC) can be made with standardized and exact photolithographic technology, for example. According to embodiments conductive pathways, tracks or signal traces, e.g. etched from at least one copper sheet (conductive layer) laminated onto a non-conductive flexible non-conductive substrate (e.g. polyimide, PEEK, TPU, polyester, etc.), may function as one or more turns of a flexible coil. Also, electronic circuits on a flexible PCB may be constructed by standardized Surface-Mount Technology (SMT), which is a method electrical components are mounted directly onto the surface of PCBs.

According to a first aspect of the present invention it is provided a method for assembling or fabricating at least one flexible electromagnetic coil, which may then serve as a loop antenna, for example. The method comprises a step of forming at least one linearly extending electric conductor in at least one electrically conductive layer of a flexible printed circuit board, wherein the flexible printed circuit board comprises at least one electrically isolating layer and the at least one electrically conductive layer. Thereby the at least one linearly extending electric conductor corresponds to at least one winding or turn of the at least one electromagnetic coil. In some embodiments the flexible coil may be used as a loop-antenna.

In the context of the present specification the term "linearly extending" shall be understood as a linear path, wherein the linear path may generally follow any trajectory in the plane of the flexible PCB in planar or deformed state.

According to embodiments the step of forming at least one linearly extending electric conductor may be performed by photolithographic processes. For example, unwanted parts of the original raw and continuously conductive layer (e.g. copper) may be removed (e.g., by etching) after applying a temporary mask, leaving only the desired conductive paths.

In some embodiments linearly extending electric conductors may be formed such that portions of the conductors run essentially in parallel to each other on the flexible printed circuit board, in order to enable good electro-magnetic properties of the flexible and flat coil. For example, the at least one linearly extending electric conductor may be formed by photolithographic technology, e.g. etching a copper layer. For high flexibility, which is beneficial for applications of the coil in or on a moving object, such as a ball, the flexible circuit board may have a thickness in the range of 0.01 mm to 1.0 mm, in particular 0.03 mm to 0.6 mm. As the flexible PCB coil is extremely flat and lightweight, it does not negatively influence flying properties of a ball when it is wound around it.

For obtaining the at least one electromagnetic coil the method may also comprise a step of bending the flexible PCB with the at least one linearly extending electric conductor to form a closed loop of the at least one linearly extending electric conductor. Thereby the bending radius may correspond to a radius of a spherical object, such as a ball, for example. In such embodiments the flat and flexible coil may easily be mounted on or underneath the surface of a ball.

In some embodiments forming the at least one linearly extending electric conductor comprises forming a plurality of separate linearly extending electric conductor paths running in parallel to each other in the at least one electrically conductive layer. Thereby each separate conductor path may have a first and a second connector or terminal on opposite ends of the flexible PCB. When forming the coil by bending or looping the flexible PCB until the opposing ends meet, corresponding first and second terminals of conductor paths may be electrically connected, e.g. by soldering or closing a plug connection, this obtaining a closed flexible coil.

Additionally or alternatively forming the at least one linearly extending electric conductor may comprise forming a wound electric conductor path having a plurality of windings or turns in the electrically conductive layer of the flexible circuit board. Thereby each winding may comprise a section or portion extending straight into a direction corresponding to the largest extension of the flexible PCB. That is to say, the wound electric conductor path may have an oval-like shape in some embodiments. In such an embodiment a coil or loop antenna is realized by said wound electric conductor path in the PCB plane. For connecting the coil to peripheral electronic components the wound electric conductor path may have one or more connector terminals.

Further, forming the at least one electromagnetic coil may comprise providing a slit in the flexible PCB with the at least one wound electric conductor path. Thereby the slit may be positioned in the center of the coil defined by the plurality of windings of the wound electric conductor path. Also, the slit may extend straight into the direction corresponding to the largest extension of the flexible PCB, i.e., it may extend essentially parallel to the section or portion of the wound electric conductor path extending straight into said direction. Appropriate folding of the flexible PCB comprising the windings and opening/spreading the slit then allows realizing a coil or loop antenna, which may be placed around a ball, without the need for soldering together the turns of the coil.

Some embodiments are particularly well-suited for accurately positioning a plurality of coils or loop antennas relative to each other on a spherical surface, which is desirable for goal-detection applications, for example. As has been explained above, the electro-magnetic properties of a ball equipped with a plurality of loop-antennas is crucial for the correct functioning and a high precision of a goal-detection system, which is based on three orthogonally arranged loop-antennas within or on a ball. Each of the three loop-antennas has a plurality of turns which may be located between within a ball, for example on a ball bladder's surface and, more particularly between the ball bladder and a ball-hull. According to some embodiments the step of forming the at least one linearly extending electric conductor may comprise forming a plurality of linearly extending electric conductors on the flexible PCB, wherein at least a first linearly extending electric conductor corresponds to a first coil, at least a second linearly extending electric conductor corresponds to a second coil, and at least a third linearly extending electric conductor corresponds to a third coil. Thereby the first coil, the second coil and the third coil are formed onto or into the flexible PCB such that three mutually orthogonal arranged coils may be obtained when the flexible PCB is mounted on a spherical surface, such as, e.g., that of a ball bladder. That is to say, according to some embodiments the three coils may be formed into the flexible PCB with predefined absolute and relative dimensions and/or distances, respectively, wherein the dimensions and distances are dependent on the size and shape of the ball. In particular the relative dimensions are chosen such that the three coils, i.e. their respective opening surfaces, are perpendicular to each other when the flexible PCB comprising the coils is placed around the spherical surface.

In some embodiments it may be beneficial to integrate more electrical components together with the at least one coil on the same flexible PCB. For example, capacitive or resistive components may be integrated together with the coil, for example, for implementing one or more resonant circuits on the flexible PCB. That is to say, in some embodiments forming the least one linearly extending electric conductor may comprise mounting or forming at least one further electric resonant circuit element on the flexible PCB, wherein the at least one electromagnetic coil and the at least one further electric resonant circuit element together form at least one resonant circuit for a predetermined frequency or frequency range. For example, frequency range may be in the sub-MHZ region, i.e., 10 kHz to 150 kHz. This may be particularly interesting for backscatter coupling concepts, wherein antennas installed at the goal may be inductively coupled with one or more coils in the ball via backscattering. Thereby backscattering (inductive coupling) uses the electro-magnetic power transmitted by a transmitter to energize the electronics in the ball. Essentially the ball reflects back some of the transmitted power, but changes some of the properties, and in this way also may send back information to the transmitter. Also, at least a part of the total electronics required in the ball may be mounted on the flexible PCB.

The method for assembling the at least one electromagnetic coil may further comprise inserting the at least one coil comprising the least one linearly extending electric conductor formed on the flexible PCB onto a spherical surface, for example between a ball bladder and a ball hull. Preferably, more than one coil is installed on the flexible PCB. In some embodiments three coils may be installed on the same flexible PCB in such a way that, when placing the flexible PCB between on the ball bladder surface, the three coils surrounding the bladder "automatically" get aligned mutually orthogonal to each other around the bladder or ball.

Embodiments are not strictly restricted to balls. Generally, a ball may be understood as any movable playing object or equipment. Therefore also an ice hockey puck may be understood as a ball in the context of this specification, for example. That is to say, the ball may belong to the group of a soccer ball, an American football ball, a Rugby ball, a basketball, a handball, a volleyball, a tennis ball, a golf ball, a billiard ball, a bowling ball, or a puck. Note that this exemplary list is not to be understood as being conclusive. Principles of the present invention may also be transferred to other items of sports equipment or playing equipment.

In some embodiments relating to a flexible coil with a plurality of separate linearly extending electric conductor paths running in parallel to each other in the at least one electrically conductive layer the step of inserting the at least one electromagnetic coil between the ball bladder and the ball hull may comprise electrically connecting corresponding first and second terminals of conductor paths on opposing ends of the conductor paths, e.g. by a further soldering step.

According to yet a further aspect it is provided a flexible electromagnetic coil comprising at least one linearly extending electric conductor formed into at least one electrically conductive layer of a flexible printed circuit board, the flexible printed circuit board comprising at least one electrically isolating layer and the at least one electrically conductive layer, wherein the at least one linearly extending electric conductor corresponds to at least one winding of the at least one electromagnetic coil.

According to yet a further aspect it is provided an item of sports equipment or playing equipment, e.g. a ball, comprising at least one flexible electromagnetic coil, the coil comprising at least one linearly extending electric conductor (path) on a flexible PCB, the flexible PCB comprising at least one electrically isolating layer and at least one electrically conductive layer. Portions of the at least one linearly extending electric conductor (path) may run essentially parallel to each other on the flexible PCB. Thereby, the at least one linearly extending electric conductor (path) forms at least one winding or turn of the at least one electromagnetic coil.

As mentioned before, the flexible PCB may comprise three electromagnetic coils arranged mutually perpendicular to each other within the ball. In particular, the three electromagnetic coils may be arranged on the same flexible and flat PCB on a spherical surface within the ball, e.g. in between a ball bladder and a ball hull or cover of the ball.

Embodiments allow simplifying the production and the exact positioning of coils or loop antennas within or on movable playing equipment, such as balls. By fabricating three orthogonal coils (when placed around the spherical surface) from one flat and flexible printed circuit board production costs may be lowered. The typically cumbersome production of the coils, which requires a lot of manual work, may be replaced by a standardized and proven production process of flexible PCBs. The placement of the coils around the circumference of the ball significantly simplifies due to a predetermined geometry which already gets specified during the PCB production. Also, the tremendous frequency tuning effort may be lowered by means of the less tolerant application process.

### Brief description of the Figures

Some embodiments of apparatuses and/or methods will be described in the following by way of example only, and with reference to the accompanying figures, in which
- Fig. 1a-d: illustrate a method for assembling or fabricating at least one flexible electromagnetic coil according to an embodiment;
- Fig. 2a, b: illustrate a flexible PCB bent to an electromagnetic coil with a plurality of turns;
- Fig. 3a: shows a first embodiment of an unwound flexible coil formed into or onto a flexible PCB;
- Fig. 3b: shows a second embodiment of an unwound flexible coil formed into or onto a flexible PCB;
- Fig. 3c: shows a third embodiment of an unwound flexible coil formed into or onto a flexible PCB
- Fig. 4: shows a first embodiment of three unwound flexible coils formed into or onto a flexible PCB;
- Fig. 5: shows a second embodiment of three unwound flexible coils formed into or onto a flexible PCB;
- Fig. 6a: schematically shows three unwound coils to be placed orthogonally around a spherical surface
- Fig. 6b: shows the three coils of Fig. 6a placed orthogonally around a spherical surface;
- Fig. 7a: illustrates a principle of a goal detection system; and
- Fig. 7b: illustrates three coils placed orthogonally underneath a ball surface.

### Description of Embodiments

Various example embodiments will now be described more fully with reference to the accompanying drawings in which some example embodiments are illustrated. In the figures, the thicknesses of lines, layers and/or regions may be exaggerated for clarity.

Accordingly, while example embodiments are capable of various modifications and alternative forms, embodiments thereof are shown by way of example in the figures and will herein be described in detail. It should be understood, however, that there is no intent to limit example embodiments to the particular forms disclosed, but on the contrary, example embodiments are to cover all modifications, equivalents, and alternatives falling within the scope of the invention. Like numbers refer to like or similar elements throughout the description of the figures.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (*e.g*., "between" versus "directly between," "adjacent" versus "directly adjacent," etc.).

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein have the same meaning as commonly understood by one of ordinary skill in the art to which example embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

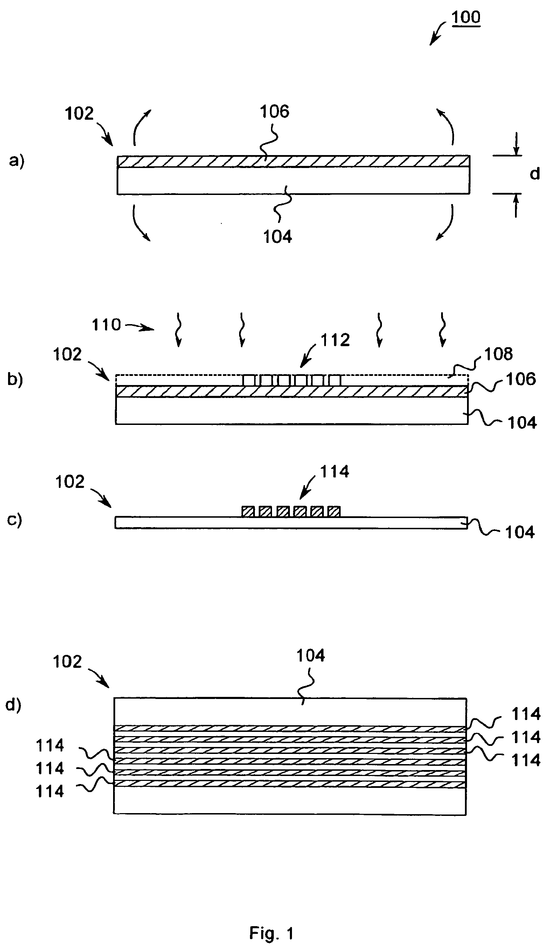

Fig. 1a to Fig 1d illustrate a method 100 for assembling or fabricating at least one flexible electromagnetic coil according to an embodiment.

Fig. 1a shows a side view of a (raw) flexible Printed Circuit Board (PCB) 102, wherein the flexible PCB 102 comprises one or more electrically isolating layers 104 and one or more electrically conductive layers 106. For example, the at least one electrically conductive layer 106 may be a metallic layer comprising, for example, copper and/or other conductive materials. The at least one electrically isolating layer 104 may comprise flexible and preferably also elastic plastic material, such as polyimide, PEEK, TPU, polyester, or combinations thereof. The flexibility of the substrate 104 is advantageous for applications of the coil in a ball, for example, which may contract and expand in particular situations (like shots, e.g.). To provide enough flexibility or softness, the flexible PCB 102 may have a thickness *d* in the range of 0.01 mm to 1 mm. In particular embodiments the thickness of the flexible and flat PCB 102 may be in the range from 0.03 mm to 0.6 mm. That is to say, high flexibility may be achieved by means of a thin core of the flexible PCB 102.

The method 100 for assembling or fabricating the at least one flexible electromagnetic coil comprises a step of forming at least one linearly extending electric conductor (path or trace) in the at least one electrically conductive layer 106 of the flexible PCB 102. Thereby the at least one linearly extending electric conductor corresponds to at least one turn or winding of the at least one electromagnetic coil. That is to say, more than one conductor paths may correspond to more than one turn of the flexible coil, which will be explained in more detail in the following.

The step of forming the at least one linearly extending electric conductor path will be detailed referring now to Fig. 1b to Fig. Id. Forming the at least one linearly extending electric conductor path on the flexible PCB 102 may be done by reproducible and exact photolithographic processes, for example. Therefore the achievable higher reproducibility may simplify tuning the coil (or a loop-antenna/resonance circuit based thereon) and shorten the production time. After having prepared the flexible PCB 102 and having applied a photoresist layer 108 on top of the metallic layer 106, which has been masked according to the desired at least one linearly extending electric conductor by exposing the photoresist 108 to light 110 (see Fig. 1b), a wet or dry chemical agent may remove the remaining parts 112 of the conductive layer 106 in the areas that are not protected by the photoresist 108. In the example illustrated in Fig. 1c, six linearly extending electric conductor paths 114 remain from the original continuously electrically conductive layer 106. Fig. Id shows the exemplary six linearly extending electric conductors or conductor paths 114 on the flexible plastic substrate 104 in a top view. Photolithographic processes used for flexible PCB fabrication are well-known and standardized. Therefore, and for the sake of brevity the photolithography will not be detailed any further.

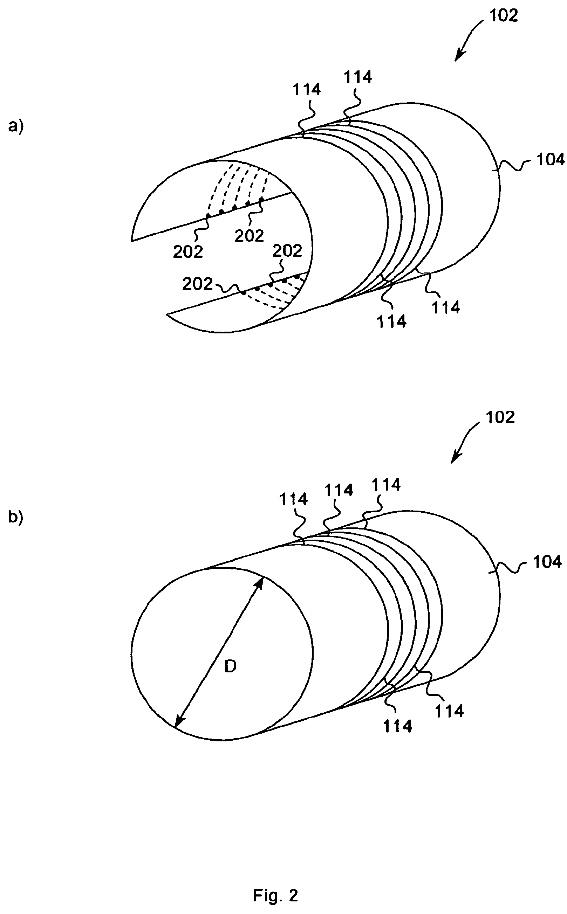

The processed flexible PCB 102 of Fig. 1d, which now comprises one or more linearly extending electric conductors 114, may now be adequately deformed or bent in order to obtain an electromagnetic coil. An exemplary loop-like deformation is illustrated in Fig. 2a and Fig. 2b.

Fig. 2a illustrates the flexible PCB 102 of Fig. 1d in a bent or deformed state. As can be seen, the flexible PCB 102 comprising the at least one linearly extending electric conductor 114 may be bent to form a closed loop of the at least one linearly extending conductor 114. In the example of Figs. 2a and 2b a plurality of exemplary six linearly extending and bent electric paths 114 is illustrated. To obtain the closed loop or coil of Fig. 2b opposing connectors or terminals 202 of the ends of the linearly extending electric conductor paths 114 may be adequately electrically interconnected, for example by soldering or plugging.

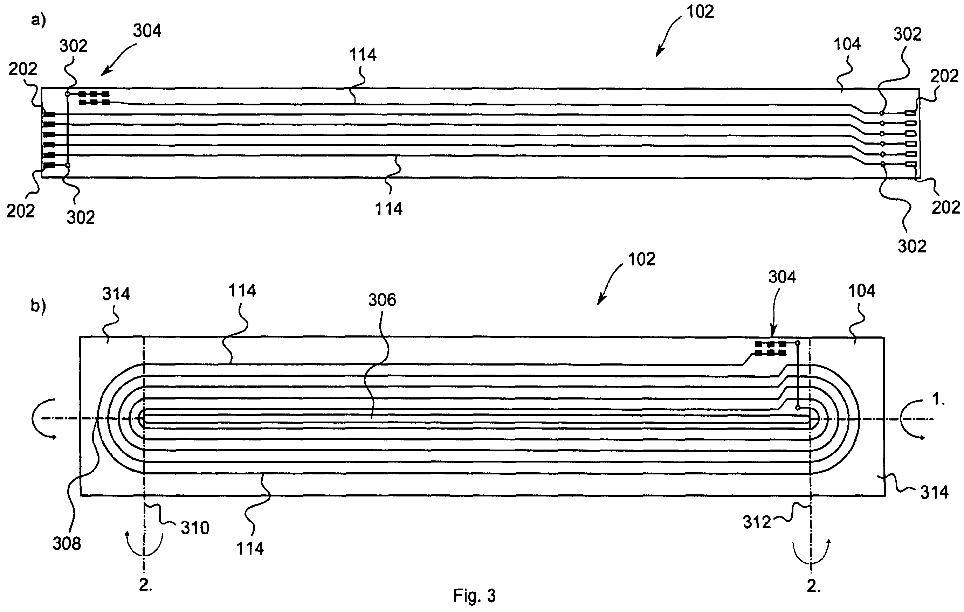

Turning now to Fig. 3a, another exemplary embodiment of an unwound flexible coil formed into or onto a flexible PCB 102 is illustrated. As can be seen, the unwound coil may be realized as a strip conductor. In this embodiment forming the at least one linearly extending electric conductor 114 comprises forming a plurality of separate straightly extending electric conductor paths (here: six, for example) 114 running essentially in parallel to each other in the at least one electrically conductive layer 106 or the remains thereof (after photolithographic processing). In other words a plurality of separate, parallel, and straight conductor paths 114 may have been etched into the conductive layer 106 on top of the flexible insulating plastic layer 104. At the end of each conductive path 114 a respective via 302 may be placed as a electrical connection between potentially different (conductive) layers of the flexible PCB 102. Each of the separate conductor paths 114 may have a first and a second connector or terminal 202 facing towards opposite ends of the flexible PCB 102. As has been explained referring to the Figs. 2a and 2b the unwound flexible coil 102 of Fig. 3a may be closed by bending the flexible coil 102 appropriately and by contacting (e.g. soldering or inter-plugging) corresponding connectors 202.

The flexible coil 102 may be connected to further resonant circuit elements by means of terminals 304. Thereby, the further resonant circuit elements, such as resistive and/or capacitive structures, may also be formed into the at least one conductive layer 106 of the flexible PCB 102. That is to say, forming the least one linearly extending electric conductor 114 into the conductive layer 106 may also comprise forming at least one further electric resonant circuit element on the flexible PCB 102, wherein the at least one electromagnetic coil and the at least one further electric resonant circuit element together form at least one resonant circuit (for inductive coupling) for a predetermined frequency or frequency range, which may be in the short wave or medium frequency region (e.g. 10 kHz to 150 kHz) for goal detection applications. Forming all resonant circuit elements together on the flexible PCB 102 may improve accuracy and ease resonance tuning.

Turning now to Fig. 3b, a further exemplary embodiment of a flexible coil formed into or onto a flexible PCB 102 is illustrated. In this embodiment forming the at least one linearly extending electric conductor 114 into the conductive layer 106 comprises forming a wound electric conductor 114 having a plurality of windings (or turns) in the electrically conductive layer 106 or on the substrate layer 104 of the flexible PCB 102. That is to say, during PCB production all the (closed) turns of the flexible coil may already be provided in the plane of the planar, non-deformed PCB 102. To be able to mount the flexible coil of Fig. 3b onto a round or spherical surface (e.g. of a ball) a slit 306 may be provided in the flexible PCB 102. Thereby, the slit 306 may be positioned in the center of the coil defined by the plurality of windings of the wound electric conductor 114. As can be seen from Fig. 3b, the slit 306 may extend straightly into the direction of the coil's largest extension within the innermost turn of the flexible coil. Thereby the slit 306 defines the diameter *D* of the coil in its bent or wound position of Fig. 2b. In order to bring the flexible PCB 102 comprising the at least one linearly extending electric conductor 114 in said position, the flexible PCB 102 may be folded around the axes 308, 310, and 312, for example, in the directions indicated by the arrows. First, the flexible PCB 102 may be folded around the axis 308 defined by the straight slit 306 to obtain to overlapping parts of the flexible coil. Second, the folded, overlapping parts of the flexible coil may be folded around the axes 310 and 312 to obtain a flat and circular flexible coil (similar to Fig. 2b) when upper and lower overlapping parts of the flexible coil are then spread apart by giving the slit 306 a circular shape. Folding the end portions 314 of the coil around the axes 310 and 310 in the indicated way allows aligning the end portions 314 in tangential direction when forming the circularly opened coil of Fig. 2b.

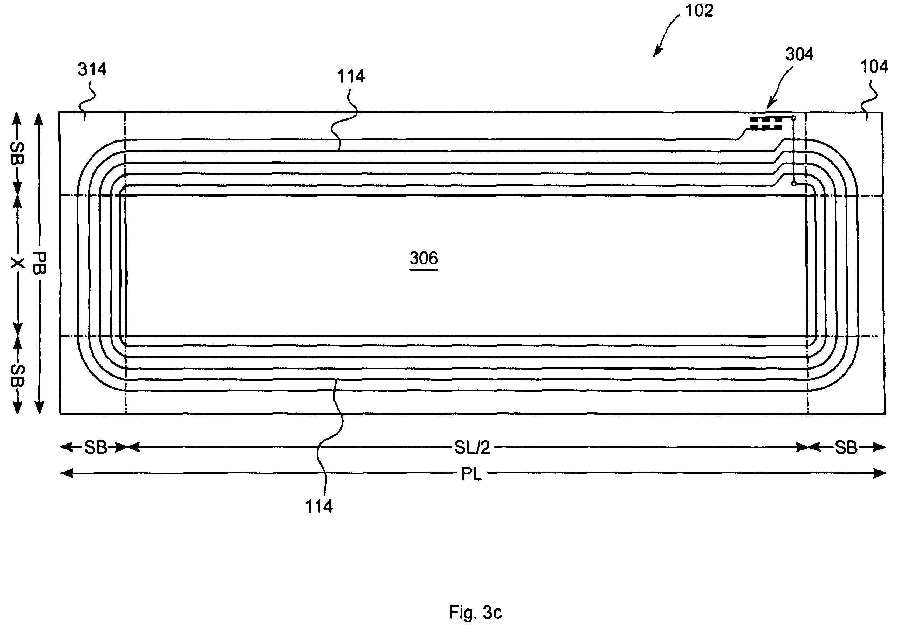

The embodiment of Fig. 3c is similar to that of Fig. 3b. However, here the slit or opening 306 is much broader having a slit width X. In Fig. 3b PB denotes the width of the flexible PCB 102, PL denotes the length of the flexible PCB 102, SB denotes the width of the plurality of conductive paths 114, and SL denotes the length of the coil. As can be seen the slit width X may be in the range of 2·SB, for example.

One advantage of embodiments according to Fig. 3b or 3c is that no extra soldering steps are necessary to close the windings or turns when assembling the flexible coil 102. Hence, a flexible coil according to Fig. 3b may be more resistant to mechanical stress, as no soldered electrical winding connection may be damaged. This may be particularly advantageous for applications where the flexible coil is inserted in elastically deformable items of sports equipment or playing equipment, such as soccer balls, for example.

As has been mentioned above, one goal-detection system proposes to install three orthogonally placed coils or loop-antennas within or on a moving object, e.g., a ball, for achieving goal detection properties which are possibly rotationally invariant. However, for optimum detection results perfect orthogonality of the three coils placed around a spherical surface is crucial. To achieve that, embodiments propose forming a plurality of linearly extending electric conductors on the PCB 102, wherein at least a first linearly extending electric conductor corresponds to a first coil, at least a second linearly extending electric conductor corresponds to a second coil, and at least a third linearly extending electric conductor corresponds to a third coil. In other words, embodiments propose to integrate three coils into one single flexible PCB 102. Thereby the first, second, and third coil may be placed on the flexible PCB 102 such that three mutually orthogonal arranged coils may be obtained when the flexible printed circuit board is arranged around a spherical surface, as, for example, the surface of a ball bladder or a ball hull.

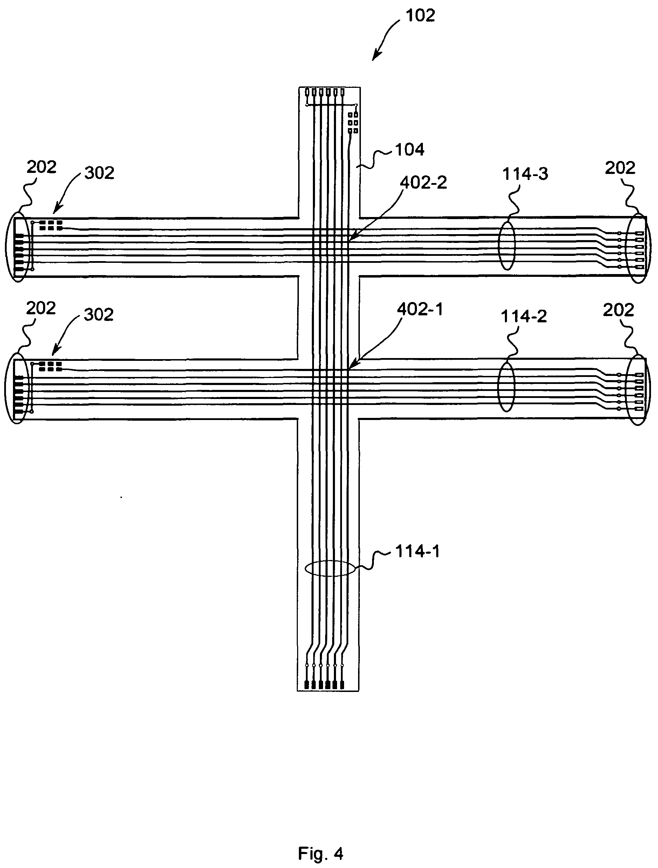

For better illustration a first embodiment of three (unwound) coils integrated into one flexible PCB is shown in Fig. 4. Thereby the respective principle of the coils corresponds to the principle explained with reference to Fig. 3a.

As can be seen in Fig. 4, forming first linearly extending electric conductors 114-1 corresponding to a first coil may comprise forming a first plurality of separate straightly extending electric conductor paths running essentially in parallel to each other in the at least one electrically conductive layer 106 or the remains thereof. Forming second linearly extending electric conductors 114-2 corresponding to a second coil may comprise forming a second plurality of separate straightly extending electric conductor paths running essentially in parallel to each other in the at least one electrically conductive layer 106. Forming third linearly extending electric conductors 114-3 corresponding to a third coil may comprise forming a third plurality of separate straightly extending electric conductor paths running essentially in parallel to each other in the at least one electrically conductive layer 106. Thereby the first, second, and third straightly extending electric conductors 114-1, 114-2, and 114-3 may run in different (i.e. separate) electrically conductive layers 106-1, 106-2, 106-3 of the flexible PCB 102, for example. As can be seen from Fig. 4, the second and third straightly extending electric conductors 114-2, 114-3 corresponding to the second and third coil may run essentially in parallel to each other, while both run perpendicular to the first straightly extending electric conductors 114-1 corresponding to the first coil. The absolute and relative dimensions of the three coils to and from each other generally depend on the geometry of the spherical object there are going to be placed at. That is to say, the distances between the two coil intersections 402-1 and 402-2 are already defined by the production process and may additionally be fixed by additional markers and fixtures.

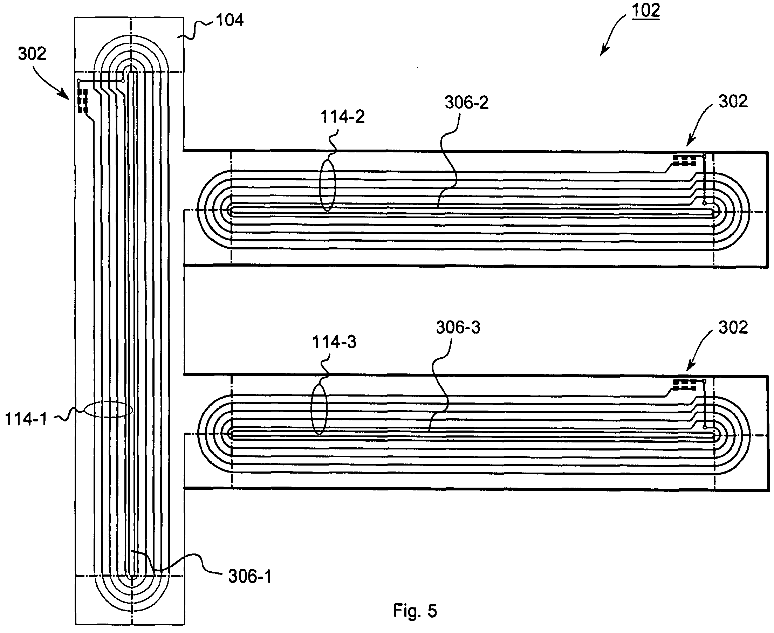

According to embodiments it is also possible to fabricate three coils from one flexible PCB when using the folding concept of Fig. 3b. Three coils fixedly arranged on one flexible PCB according to the folding concept are illustrated in Fig. 5.

In this embodiment forming the three coils comprises forming, in the conductive layer 106, a first wound electric conductor 114-1 corresponding to a first coil, the first electric conductor 114-1 having a plurality of windings in the electrically conductive layer 106. Further, a second wound and linearly extending electric conductor 114-2 corresponding to a second coil is formed into the flexible PCB 102, wherein the second electric conductor 114-2 also has a plurality of windings in the electrically conductive layer 106. Thirdly, a third wound and linearly extending electric conductor 114-3 corresponding to a third coil is formed into the flexible PCB 102, wherein the third electric conductor 114-2 may also have a plurality of windings in the electrically conductive layer 106. That is to say, during PCB production all the (closed) turns of the three flexible coils may already be provided in the plane of the planar, non-deformed PCB 102. According to Fig. 5 the three planar coils are non-overlapping. To be able to mount the three flexible coils of Fig. 5 onto a spherical surface (e.g. of a ball) each coil is provided with a respective slit 306-1, 306-2, and 306-3 separating an upper half of the respective coil-windings from a lower half. In order to bring the flexible PCB 102 comprising the three linearly extending electric conductors 114-1, 114-2, and 114-3 in a state suited for a spherical surface, each coil may be folded along the axes 308, 310, 312, as has been explained with reference to Fig. 3b.

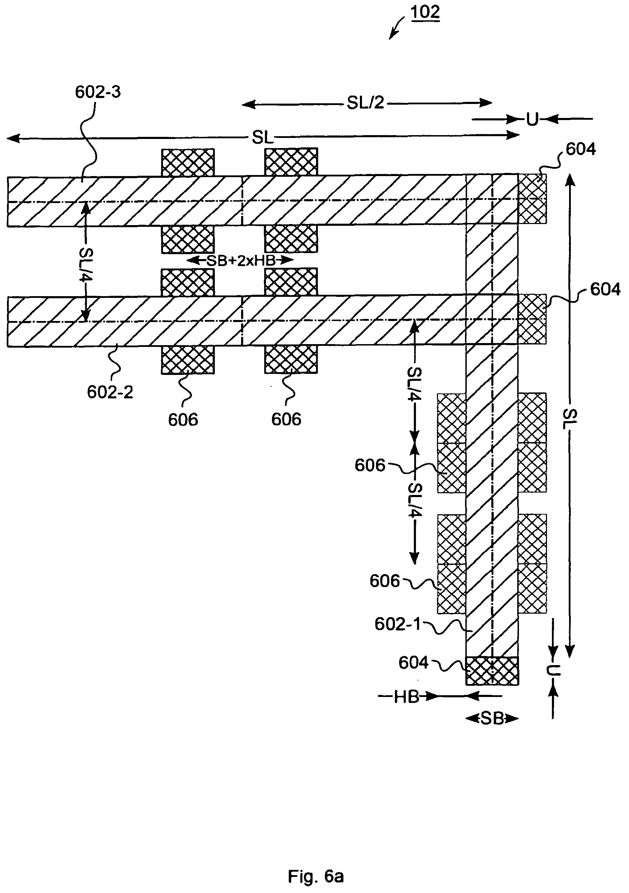

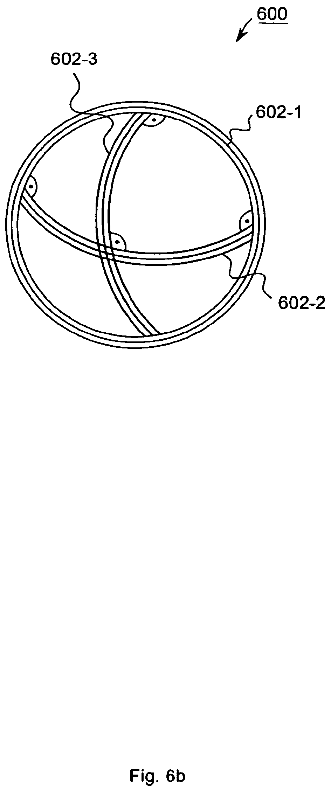

Embodiments of the flexible coil(s) according to Fig. 1 to Fig. 5 may be arranged around a spherical surface, such the opening planes of the three coils are mutually orthogonal to each other. Fig. 6a illustrates a schematic example of a flexible PCB 102 with three integrated coils 602-1, 602-2, and 602-3. The coils each comprise fixation elements 604 and 606, respectively, the elements 604 providing overlap U and the elements 606 having a width HB. While the fixation elements or overlap area 604 may serve for joining opposing ends of the same coil, respectively, the fixation elements 606 may serve for fixing or immobilizing intersections of different coils in order to fix the relative positions of the coils 602-1, 602-2, and 602-3 to each other on the spherical surface. Thereby fixation or joining may e.g. be done by adhesives, by melding, or by forming fixation lugs from the fixation elements or wings 606. The three assembled coils 602-1, 602-2, and 602-3 arranged around a spherical surface are exemplarily illustrated in Fig. 6b.

Fig. 6b illustrates an orthogonal arrangement 600 of three flat and flexible coils 602-1, 602-2, and 602-3 according to an embodiment. The flexible coils 602-1, 602-2, and 602-3 are orthogonally arranged around a spherical surface, which may correspond to a ball, a ball bladder, a ball hull, or the like. Hence, the method 100 may also comprise mounting at least one electromagnetic coil, preferably three, each comprising the least one linearly extending electric conductor 114 formed on the flexible PCB into or onto a spherical surface, e.g. of a ball. According to one embodiment the three flexible coils 602-1, 602-2, and 602-3 may be inserted in between a ball bladder and a ball hull. Thereby "orthogonally arranging" may be understood as arranging the three coils 602-1, 602-2, 602- 3 such that the linearly extending conductor paths 114 of two different coils are essentially perpendicular to each other at their points of intersection. In order to have defined and fixed intersection points between to different coils special fixation elements 606 for or at the intersection points may be provided, such as lugs, feed-throughs or the like.

As a consequence embodiments may also comprise a ball which comprises at least one flexible electromagnetic coil according to an embodiment. That is to say, the at least one flexible coil in the ball comprises at least one linearly extending electric conductor in at least one electrically conductive layer of a flexible printed circuit board, the flexible printed circuit board comprising at least one electrically isolating layer and the at least one electrically conductive layer. Thereby the at least one linearly extending electric conductor corresponds to at least one winding of the at least one electromagnetic coil. In particular, the flexible PCB may comprise three electromagnetic coils arranged mutually perpendicular to each other within the ball. In some embodiments the flexible PCB of the three electromagnetic coils may be arranged in between a ball bladder and a ball hull of the ball.

To summarize, embodiments allow realizing a coil by means of a flexible PCB. Therewith the production, the lifetime and the accuracy of coil arrangements within items of sports equipment, such as balls, for example, may be improved. By means or the standardized production process the exact position of the conductive paths, and hence the coils, may be predetermined. Also the relative position of the individual coils to each other may be exactly predefined by means of the common PCB production process, e.g. photolithographic steps. Embodiments may enable simpler and hence cheaper ball production for goal detection systems. Due to the improved lifetime of the electronics in the ball running goal detection systems gets more inexpensive as well. Due to fewer tolerances in (flexible) PCB production processes the effort for tuning the resonance circuits becomes less.

In other words embodiments provided an item of sports equipment, for example a ball for a ball game, for example handball, football or American football, or a puck having at least one coil, wherein the at least one coil is arranged on a flexible printed circuit board.

Thereby the item of sports equipment may comprise a plurality of coils. The coils of the plurality of coils may have, at least partially or completely, an angle with respect to one another that differs from 0° and an angle that differs from an integral multiple of 180°. In particular the angle with respect to one another may essentially be 90°. Also, embodiments provide a method for providing an item of sports equipment, for example a ball for a ball game, for example handball, football, or American football, or a puck having at least one coil, wherein the method comprises providing a flexible printed circuit board, applying at least one coil to the flexible printed circuit board, providing a starting material for a cover of the item of sports equipment, and assembling the starting material and the flexible substrate with the at least one coil, with the result that the item of sports equipment with the at least one coil is provided. Thereby the assembly may be performed in such a way that the at least one coil is arranged on an inner side of the item of sports equipment.

The description and drawings merely illustrate the principles of the invention. It will thus be appreciated that those skilled in the art will be able to devise various arrangements that, although not explicitly described or shown herein, embody the principles of the invention and are included within its spirit and scope. Although embodiments have been illustrated with respect to goal-detection systems, alternative embodiments may also related to anti-theft devices (e.g. the insertion of flexible coils into or onto goods), further sports, like e.g. ice hockey. Also, embodiments may be useful for surveiling safety areas, for example by integrating flexible and flat coils in shoes or the like.

Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

It is further to be noted that methods disclosed in the specification or in the claims may be implemented by a device having means for performing each of the respective steps of these methods.

Further, it is to be understood that the disclosure of multiple steps or functions disclosed in the specification or claims may not be construed as to be within the specific order. Therefore, the disclosure of multiple steps or functions will not limit these to a particular order unless such steps or functions are not interchangeable for technical reasons. Furthermore, in some embodiments a single step may include or may be broken into multiple sub steps. Such sub steps may be included and part of the disclosure of this single step unless explicitly excluded.

## Claims

1. Method (100) for assembling at least one flexible electromagnetic coil for a ball, the method comprising:
forming at least one linearly extending electric conductor (114) in at least one electrically conductive layer (106) of a flexible printed circuit board (102), the flexible printed circuit board (102) comprising at least one electrically isolating layer (104) and the at least one electrically conductive layer (106), wherein the at least one linearly extending electric conductor (114) corresponds to at least one winding of the at least one electromagnetic coil,
wherein forming the at least one linearly extending electric conductor (114) comprises forming a plurality of linearly extending electric conductors (114) on the flexible printed circuit board (102), wherein at least a first linearly extending electric conductor (114-1) corresponds to a first coil (602-1), at least a second linearly extending electric conductor (114-2) corresponds to a second coil (602-2), and at least a third linearly extending electric conductor (114-3) corresponds to a third coil (602-3),
wherein the first, second, and third coil (602-1; 602-2; 602-3) are formed on the flexible printed circuit board (102) such that three mutually perpendicular arranged coils (602-1; 602-2; 602-3) are obtained when the flexible printed circuit board (102) is arranged around a spherical surface within the ball; and
arranging the flexible printed circuit board (102) comprising the three electromagnetic coils (602-1; 602-2; 602-3) around said spherical surface.

2. The method (100) according to claim 1, wherein forming the at least one linearly extending electric conductor (114) comprises etching the electrically conductive layer (106).

3. The method (100) according to claim 1 or 2, wherein the at least one electrically isolating layer (104) belongs to the group of polyimide, polyether ether ketone (PEEK), thermoplastic polyurethane (TPU), or polyester.

4. The method (100) according to one of the preceding claims, wherein the flexible printed circuit board (102) has a thickness in the range of 0.01 mm to 1 mm.

5. The method (100) according to one of the preceding claims, wherein forming the at least one linearly extending electric conductor (114) comprises forming a plurality of linearly extending electric conductors running in parallel to each other in the at least one electrically conductive layer (106), each conductor having a first and a second connector (202) on opposite ends of the flexible printed circuit board (102).

6. The method (100) according to one of claims 1 to 4, wherein forming the at least one linearly extending electric conductor (114) comprises forming a wound electric conductor having a plurality of windings in the electrically conductive layer (106) of the flexible printed circuit board (102).

7. The method (100) according to claim 6, wherein assembling the at least one electromagnetic coil further comprises providing a slit (306) in the flexible printed circuit board (102), wherein the slit (306) is positioned in the center of the coil defined by the plurality of windings of the wound electric conductor (114).

8. The method (100) according to one of the preceding claims, wherein forming the least one linearly extending electric conductor (114) comprises forming at least one further electric resonant circuit element on the flexible printed circuit board (102), wherein the at least one electromagnetic coil and the at least one further electric resonant circuit element together form at least one resonant circuit for a predetermined frequency.

9. The method (100) according to one of the preceding claims, wherein the method further comprises:
bending the flexible printed circuit board (102) with the at least one linearly extending electric conductor (114) to form a closed loop of the at least one linearly extending electric conductor (114).

10. The method (100) according to one of the preceding claims, wherein the ball belongs to the group of a soccer ball, an American football ball, a Rugby ball, a basketball, a handball, a volleyball, a tennis ball, a bowling ball, a billiard ball, a golf ball, or a puck.

11. The method (100) according to one of the preceding claims, wherein arranging the flexible printed circuit board (102) around the spherical surface comprises electrically connecting corresponding connectors (202) on opposing ends of the least one linearly extending electric conductor (114).

12. The method (100) according to claim 11, wherein electrically connecting comprises soldering the corresponding connectors (202) and/or closing plug connections of the corresponding connectors (202).

13. The method (100) according to one of the preceding claims, wherein arranging the flexible printed circuit board (102) comprises arranging the three electromagnetic coils around a ball bladder in between the ball bladder and a ball cover of the ball.

14. The method (100) according to one of the preceding claims, wherein arranging the flexible printed circuit board (102) comprises arranging the three electromagnetic coils around the circumference of the ball, respectively.

15. A ball comprising at least one flexible electromagnetic coil, the flexible coil comprising at least one linearly extending electric conductor (114) formed into at least one electrically conductive layer (106) of a flexible printed circuit board (102), the flexible printed circuit board (102) comprising at least one electrically isolating layer (104) and the at least one electrically conductive layer (106), wherein the at least one linearly extending electric conductor (114) corresponds to at least one winding of the at least one flexible electromagnetic coil,
**characterized in that**
the flexible printed circuit board (102) comprises three electromagnetic coils (602-1; 602-2; 602-3) arranged mutually perpendicular to each other around a spherical surface within the ball.

## Patentansprüche

1. Verfahren (100) für ein Zusammensetzen von zumindest einer flexiblen elektromagnetischen Spule für einen Ball, umfassend:
Bilden von zumindest einem sich linear erstreckenden, elektrischen Leiter (114) in zumindest einer elektrisch leitfähigen Schicht (106) einer flexiblen gedruckten Schaltungsplatine (102), wobei die flexible gedruckte Schaltungsplatine (102) zumindest eine elektrisch isolierende Schicht (104) und die zumindest eine elektrisch leitfähige Schicht (106) umfasst, wobei der zumindest eine sich linear erstreckende, elektrische Leiter (114) zumindest einer Wicklung der zumindest einen elektromagnetischen Spule entspricht,
wobei das Bilden des zumindest einen sich linear erstreckenden, elektrischen Leiters (114) ein Bilden einer Mehrzahl von sich linear erstreckenden, elektrischen Leitern (114) auf der flexiblen gedruckten Schaltungsplatine (102) umfasst, wobei zumindest ein erster sich linear erstreckender, elektrischer Leiter (114-1) einer ersten Spule (602-1) entspricht, zumindest ein zweiter sich linear erstreckender, elektrischer Leiter (114-2) einer zweiten Spule (602-2) entspricht, und zumindest ein dritter sich linear erstreckender, elektrischer Leiter (114-3) einer dritten Spule (602-3) entspricht,
wobei die erste, zweite und dritte Spule (602-1; 602-2; 602-3) auf der flexiblen gedruckten Schaltungsplatine (102) gebildet sind, derart, dass drei zueinander perpendikulär angeordnete Spulen (602-1; 602-2; 602-3) erhalten werden, wenn die flexible gedruckte Schaltungsplatine (102) um eine kugelige Oberfläche herum innerhalb des Balls angeordnet ist; und
Anordnen der flexiblen gedruckten Schaltungsplatine (102), die die drei elektromagnetischen Spulen (602-1; 602-2; 602-3) umfasst, um die kugelige Oberfläche herum.

2. Das Verfahren (100) gemäß Anspruch 1, wobei das Bilden des zumindest einen sich linear erstreckenden, elektrischen Leiters (114) ein Ätzen der elektrisch leitfähigen Schicht (106) umfasst.

3. Das Verfahren (100) gemäß Anspruch 1 oder 2, wobei die zumindest eine elektrisch isolierende Schicht (104) zu der Gruppe von Polyimid, Polyetheretherketon (PEEK), thermoplastischem Polyurethan (TPU) oder Polyester gehört.

4. Das Verfahren (100) gemäß einem der vorangehenden Ansprüche, wobei die flexible gedruckte Schaltungsplatine (102) eine Dicke in dem Bereich von 0,01 mm bis 1 mm aufweist.

5. Das Verfahren (100) gemäß einem der vorangehenden Ansprüche, wobei das Bilden des zumindest einen sich linear erstreckenden, elektrischen Leiters (114) ein Bilden einer Mehrzahl von sich linear erstreckenden, elektrischen Leitern umfasst, die parallel zu einander in der zumindest einen elektrisch leitfähigen Schicht (106) verlaufen, wobei jeder Leiter einen ersten und einen zweiten Verbinder (202) an gegenüberliegenden Enden der flexiblen gedruckten Schaltungsplatine (102) aufweist.

6. Das Verfahren (100) gemäß einem der Ansprüche 1 bis 4, wobei das Bilden des zumindest einen sich linear erstreckenden, elektrischen Leiters (114) ein Bilden eines gewickelten elektrischen Leiters, der eine Mehrzahl von Wicklungen aufweist, in der elektrisch leitfähigen Schicht (106) der flexiblen gedruckten Schaltungsplatine (102) umfasst.

7. Das Verfahren (100) gemäß Anspruch 6, wobei das Zusammensetzen der zumindest einen elektromagnetischen Spule ferner ein Bereitstellen eines Schlitzes (306) in der flexiblen gedruckten Schaltungsplatine (102) umfasst, wobei der Schlitz (306) in der Mitte der Spule positioniert wird, die durch die Mehrzahl von Wicklungen des gewickelten elektrischen Leiters (114) definiert ist.

8. Das Verfahren (100) gemäß einem der vorangehenden Ansprüche, wobei das Bilden des zumindest einen sich linear erstreckenden, elektrischen Leiters (114) ein Bilden von zumindest einem weiteren Elektrisch-Schwingkreis-Element auf der flexiblen gedruckten Schaltungsplatine (102) umfasst, wobei die zumindest eine elektromagnetische Spule und das zumindest eine weitere Elektrisch-Schwingkreis-Element zusammen zumindest einen Schwingkreis für eine vorbestimmte Frequenz bilden.

9. Das Verfahren (100) gemäß einem der vorangehenden Ansprüche, ferner umfassend:
Biegen der flexiblen gedruckten Schaltungsplatine (102) mit dem zumindest einen sich linear erstreckenden, elektrischen Leiter (114), um eine geschlossene Schleife des zumindest einen sich linear erstreckenden, elektrischen Leiters (114) zu bilden.

10. Das Verfahren (100) gemäß einem der vorangehenden Ansprüche, wobei der Ball zu der Gruppe von einem Fußball, einem American-Football-Ball, einem Rugby-Ball, einem Basketball, einem Handball, einem Volleyball, einem Tennisball, einer Bowlingkugel, einer Billardkugel, einem Golfball oder einem Puck gehört.

11. Das Verfahren (100) gemäß einem der vorangehenden Ansprüche, wobei das Anordnen der flexiblen gedruckten Schaltungsplatine (102) um die kugelige Oberfläche herum ein elektrisches Verbinden von entsprechenden Verbindern (202) an gegenüberliegenden Enden des zumindest einen sich linear erstreckenden, elektrischen Leiters (114) umfasst.

12. Das Verfahren (100) gemäß Anspruch 11, wobei das elektrische Verbinden ein Löten der entsprechenden Verbinder (202) und/oder ein Schließen von Steckverbindungen der entsprechenden Verbinder (202) umfasst.

13. Das Verfahren (100) gemäß einem der vorangehenden Ansprüche, wobei das Anordnen der flexiblen gedruckten Schaltungsplatine (102) ein Anordnen der drei elektromagnetischen Spulen um eine Ballblase herum zwischen der Ballblase und einer Ballhülle des Balls umfasst.

14. Das Verfahren (100) gemäß einem der vorangehenden Ansprüche, wobei das Anordnen der flexiblen gedruckten Schaltungsplatine (102) ein Anordnen der drei elektromagnetischen Spulen jeweils um den Umfang des Balls herum umfasst.

15. Ein Ball, umfassend zumindest eine flexible elektromagnetische Spule, wobei die flexible Spule zumindest einen sich linear erstreckenden, elektrischen Leiter (114) umfasst, der in zumindest eine elektrisch leitfähige Schicht (106) einer flexiblen gedruckten Schaltungsplatine (102) gebildet ist, wobei die flexible gedruckte Schaltungsplatine (102) zumindest eine elektrisch isolierende Schicht (104) und die zumindest eine elektrisch leitfähige Schicht (106) umfasst, wobei der zumindest eine sich linear erstreckende, elektrische Leiter (114) zumindest einer Wicklung der zumindest einen flexiblen elektromagnetischen Spule entspricht,
**dadurch gekennzeichnet, dass**
die flexible gedruckte Schaltungsplatine (102) drei elektromagnetische Spulen (602-1; 602-2; 602-3) umfasst, die zueinander perpendikulär um eine kugelige Oberfläche herum innerhalb des Balls angeordnet sind.

## Revendications

1. Procédé (100) pour assembler au moins une bobine électromagnétique flexible pour un ballon, le procédé comprenant le fait de:
former au moins un conducteur électrique s'étendant linéairement (114) dans au moins une couche électroconductrice (106) d'une carte à circuit imprimé flexible (102), la carte à circuit imprimé flexible (102) comprenant au moins une couche électro-isolante (104) et au moins une couche électroconductrice (106), dans lequel le au moins un conducteur électrique s'étendant linéairement (114) correspond à au moins un enroulement de la au moins une bobine électromagnétique,
dans lequel le fait de former le au moins un conducteur électrique s'étendant linéairement (114) comprend le fait de former une pluralité de conducteurs électriques s'étendant linéairement (114) sur la carte à circuit imprimé flexible (102), dans lequel au moins un premier conducteur électrique s'étendant linéairement (114-1) correspond à une première bobine (602-1), au moins un deuxième conducteur électrique s'étendant linéairement (114-2) correspond à une deuxième bobine (602-2), et au moins un troisième conducteur électrique s'étendant linéairement (114-3) correspond à une troisième bobine (602-3),
dans lequel les première, deuxième et troisième bobines (602-1; 602-2; 602-3) sont formées sur la carte à circuit imprimé flexible (102) de sorte que trois bobines placées mutuellement perpendiculairement (602-1; 602-2; 602-3) sont obtenues lorsque la carte à circuit imprimé flexible (102) est placée autour d'une surface sphérique dans le ballon ; et
placer la carte à circuit imprimé flexible (102) comprenant les trois bobines électromagnétiques (602-1; 602-2; 602-3) autours de ladite surface sphérique.

2. Procédé (100) selon la revendication 1, dans lequel le fait de former le au moins un conducteur électrique s'étendant linéairement (114) comprend le fait de graver la couche électroconductrice (106).

3. Procédé (100) selon la revendication 1 ou 2, dans lequel la au moins une couche électro-isolante (104) appartient au groupe comprenant polyimide, polyétheréthercétone (PEEK), polyuréthane thermoplastique (TPU) ou polyester.

4. Procédé (100) selon l'une des revendications précédentes, dans lequel la carte à circuit imprimé flexible (102) a une épaisseur de l'ordre de 0,01 mm à 1 mm.

5. Procédé (100) selon l'une des revendications précédentes, dans lequel le fait de former le au moins un conducteur électrique s'étendant linéairement (114) comprend le fait de former une pluralité de conducteurs électriques s'étendant linéairement disposés en parallèle les uns aux autres dans la au moins une couche électroconductrice (106), chaque conducteur comportant un premier et un deuxième connecteur (202) sur des extrémités opposées de la carte à circuit imprimé flexible (102).

6. Procédé (100) selon l'une des revendications 1 to 4, dans lequel le fait de former le au moins un conducteur électrique s'étendant linéairement (114) comprend le fait de former un conducteur électrique enroulé comportant une pluralité d'enroulements dans la couche électroconductrice (106) de la carte à circuit imprimé flexible (102).

7. Procédé (100) selon la revendication 6, dans lequel le fait d'assembler la au moins une bobine électromagnétique comprend en outre le fait de fournir une fente (306) dans la carte à circuit imprimé flexible (102), dans lequel la fente (306) est positionnée au centre de la bobine défini par la pluralité d'enroulements du conducteur électrique enroulé (114).

8. Procédé (100) selon l'une des revendications précédentes, dans lequel le fait de former le au moins un conducteur électrique s'étendant linéairement (114) comprend le fait de former au moins un élément de circuit résonnant électrique sur la carte à circuit imprimé flexible (102), dans lequel la au moins une bobine électromagnétique et le au moins un autre élément de circuit résonnant électrique ensemble forment au moins un circuit résonnant pour une fréquence prédéterminée.

9. Procédé (100) selon l'une des revendications précédentes, le procédé comprenant en outre le fait de:
cintrer la carte à circuit imprimé flexible (102) avec le au moins un conducteur électrique s'étendant linéairement (114) pour former une boucle fermée du au moins un conducteur électrique s'étendant linéairement (114).

10. Procédé (100) selon l'une des revendications précédentes, dans lequel le ballon appartient au groupe comprenant un ballon de football, un ballon de football américain, un ballon de rugby, un ballon de basket, un ballon de handball, une balle de volley-ball, une balle de tennis, une boule de bowling, une boule de billard, une balle de golf ou un palet.

11. Procédé (100) selon l'une des revendications précédentes, dans lequel le fait de placer la carte à circuit imprimé flexible (102) autours de la surface sphérique comprend le fait de connecter électriquement des connecteurs correspondants (202) à des extrémités opposées du au moins un conducteur électrique s'étendant linéairement (114).

12. Procédé (100) selon la revendication 11, dans lequel le fait de connecter électriquement comprend le fait de souder les connecteurs correspondants (202) et/ou le fait de fermer des connexions par enfichage des connecteurs correspondants (202).

13. Procédé (100) selon l'une des revendications précédentes, dans lequel le fait de placer la carte à circuit imprimé flexible (102) comprend le fait de placer les trois bobines électromagnétiques autours d'une vessie de ballon entre la vessie de ballon et une enveloppe de ballon du ballon.

14. Procédé (100) selon l'une des revendications précédentes, dans lequel le fait de placer la carte à circuit imprimé flexible (102) comprend le fait placer les trois bobines électromagnétiques respectivement autours de la circonférence du ballon.

15. Ballon comprenant au moins une bobine électromagnétique flexible, la bobine flexible comprenant au moins un conducteur électrique s'étendant linéairement (114) formé dans au moins une couche électroconductrice (106) d'une carte à circuit imprimé flexible (102), la carte à circuit imprimé flexible (102) comprenant au moins une couche électro-isolante (104) et la au moins une couche électroconductrice (106), dans lequel le au moins un conducteur électrique s'étendant linéairement (114) correspond à au moins un enroulement de la au moins une bobine électromagnétique flexible,
**caractérisé en ce que**
la carte à circuit imprimé flexible (102) comprend trois bobines électromagnétiques (602-1; 602-2; 602-3) placées mutuellement perpendiculaires les unes aux autres autours d'une surface sphérique dans le ballon.
